# EUROPEAN PATENT APPLICATION

(11) **EP 3 787 037 A1**
(43) Date of publication of application: **03.03.2021**
(21) Application number: 20192886.8
(22) Date of filing: 26.08.2020
(51) Int. Cl.: H01L 31/048, H01L 31/05

(54) **SOLAR CELL MODULE**

(30) Priority: 28.08.2019 JP 2019155982
(71) Applicant: Panasonic Corporation, Osaka 571-8501 (JP)
(72) Inventor: NAKAMURA, Yuya, Osaka-shi, Osaka 540-6207 (JP); YAMAZAKI, Atsuko, Osaka-shi, Osaka 540-6207 (JP); KANNO, Hiroshi, Osaka-shi, Osaka 540-6207 (JP)
(74) Representative: Müller-Boré & Partner Patentanwälte PartG mbB

(57) **Abstract**

A 12th solar cell includes a light receiving surface and a back surface that face in opposite directions. A first adhesion layer adhesively attaches a wire to the light receiving surface, and a second adhesion layer that adhesively attaches a wire to the back surface. A first encapsulant encapsulates the 12th solar cell from a side of the light receiving surface, and a second encapsulant encapsulates the 12th solar cell from a side of the back surface. An amount of antioxidant contained in the first adhesion layer and the second adhesion layer is equal to or larger than an amount of antioxidant contained in the first encapsulant.

## Description

### CROSS-REFERENCE TO RELATED APPLICATION

This application is based upon and claims the benefit of priority from the prior Japanese Patent Application No. 2019-155982, filed on August 28, 2019, the entire contents of which are incorporated herein by reference.

### BACKGROUND

### 1. Field

The present disclosure relates to a solar cell module and, more particularly, to a solar cell module including a solar cell.

### 2. Description of the Related Art

Two films interconnected by wires are used to make it easy to manufacture a solar cell module. One of the two films is attached to the light receiving surface of a solar cell and sandwiches wires between the film and the light receiving surface. Further, the other of the two films is attached to the back surface of a further solar cell and sandwiches the wires between the film and the back surface (see, for example, JP2018-530168).

In a solar cell, a plurality of wires are connected by the adhesion layer in the film to each of the light receiving surface and the back surface. Further, the solar cell is encapsulated by an encapsulant provided between a protection member on the light receiving surface side (hereinafter, referred to as "first protection member") and a protection member on the back surface side (hereinafter, referred to as "second protection member"). In the case the wire contains copper, the adhesion layer and the encapsulant may be affected by copper hazards.

### SUMMARY

The disclosure addresses the above-described issue, and a general purpose thereof is to provide a technology of inhibiting the impact from copper hazards.

A solar cell module according to an embodiment of the present disclosure includes: a solar cell including a first surface and a second surface that face in opposite directions; a first adhesion layer that adhesively attaches a first wiring member to the first surface; a second adhesion layer that adhesively attaches a second wiring member to the second surface; a first encapsulant that encapsulates the solar cell from a side of the first surface to which the first wiring member is adhesively attached by the first adhesion layer; and a second encapsulant that encapsulates the solar cell from a side of the second surface to which the second wiring member is adhesively attached by the second adhesion layer. An amount of antioxidant contained in the first adhesion layer and the second adhesion layer is equal to or larger than an amount of antioxidant contained in the first encapsulant.

### BRIEF DESCRIPTION OF THE DRAWINGS

The figures depict one or more implementations in accordance with the present teaching, by way of example only, not by way of limitations. In the figures, like reference numerals refer to the same or similar elements.
Fig. 1 is a plan view showing a structure of a solar cell module according to embodiment 1;
Fig. 2 is a cross-sectional view showing a structure of the solar cell module of Fig. 1;
Fig. 3 is a perspective view showing a structure of a wire film used in the solar cell module of Fig. 2;
Figs. 4A-4B are cross-sectional views showing a structure of the first film and the second film exhibited before they are attached to the solar cell of Fig. 2;
Figs. 5A-5D are further cross-sectional views showing a structure of the solar cell module of Fig. 1;
Figs. 6A-6B are plan views showing a structure of the solar cell of Fig. 1; and
Figs. 7A-7B are cross-sectional views showing a structure of the solar cell module according to embodiment 2.

### DETAILED DESCRIPTION

The disclosure will now be described by reference to the preferred embodiments. This does not intend to limit the scope of the present disclosure, but to exemplify the disclosure.

### (Embodiment 1)

A brief summary will be given before describing the present disclosure in specific details. An embodiment of the present disclosure relates to a solar cell module in which a plurality of solar cells are arranged in a matrix. In a solar cell module, the first protection member, the first encapsulant, the second encapsulant, and the second protection member are arranged in the stated order in the direction away from the light receiving surface side toward the back surface side. In this process, two adjacent solar cells are connected by a wire film. A wire film is configured as two films connected by a plurality of wires, and the adhesion layers of the respective films are attached to the respective solar cells, thereby connecting the finger electrodes of the respective solar cells by the plurality of wires. Since the wire plays the role of a wiring member, a string is formed by a plurality of solar cells arranged in a direction of extension of the wire. A wire film like this is used to make it easy to manufacture a solar cell module.

One of these two films (hereinafter, referred to as "first film") is attached by the adhesion layer (hereinafter, referred to as "first adhesion layer") to the light receiving surface of one solar cell. The other of the two films (hereinafter, referred to as "second film") is attached by the adhesion layer (hereinafter, referred to as "second adhesion layer") to the back surface of the adjacent solar cell. Thus, by using a wire film in a solar cell module, the first film, the first adhesion layer, the solar cell, the second adhesion layer, and the second film are arranged between the first encapsulant and the second encapsulant in a direction away from the first encapsulant toward the second encapsulant. In the case the wire contains copper, the portion near the wire is affected by copper hazards and changes its color to, for example, brown. This results in degraded aesthetic appearance of the solar cell module as viewed from outside.

In order to inhibit the aesthetic appearance from becoming degraded due to the impact from copper hazards, an antioxidant is contained in the first adhesion layer, the second adhesion layer, etc. of the solar module according to this embodiment. Meanwhile, an increase in the amount of antioxidant changes the physical property exemplified by lower adhesiveness. In order to inhibit the change in physical property, the solar cell module according to this embodiment is configured such that the amount of antioxidant contained in the first adhesion layer and the second adhesion layer is configured to be equal to or larger than the amount of antioxidant contained in the first encapsulant. The terms "parallel" and "orthogonal" in the following description not only encompass completely parallel or orthogonal but also encompass slightly off-parallel and off-orthogonal within the margin of error. The term "substantially" means identical within certain limits.

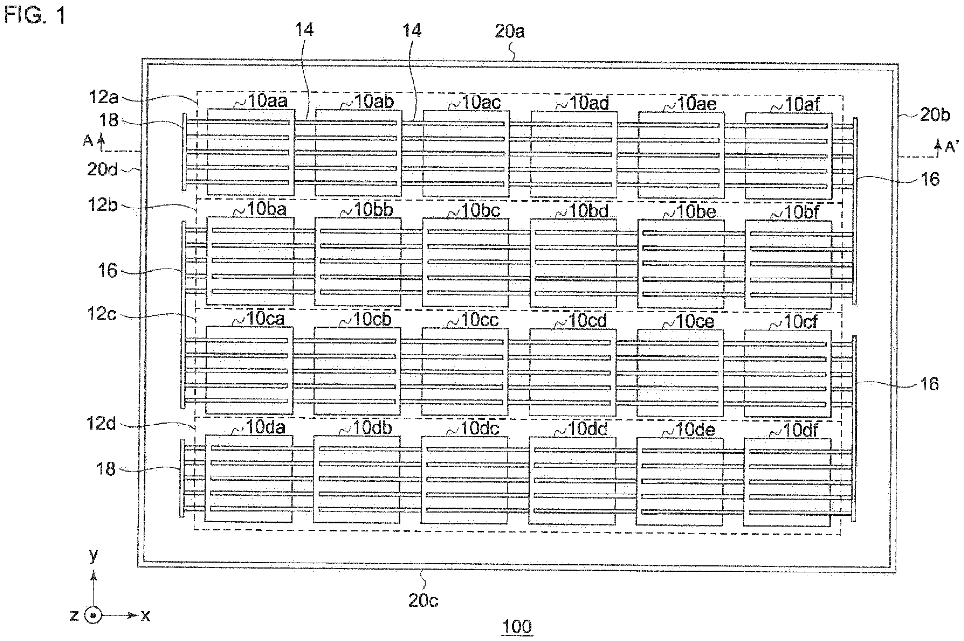

Fig. 1 is a plan view showing a structure of a solar cell module 100. As shown in Fig. 1, an orthogonal coordinate system including an x axis, y axis, and a z axis is defined. The x axis and y axis are orthogonal to each other in the plane of the solar cell module 100. The z axis is perpendicular to the x axis and y axis and extends in the direction of thickness of the solar cell module 100. The positive directions of the x axis, y axis, and z axis are defined in the directions of arrows in Fig. 1, and the negative directions are defined in the directions opposite to those of the arrows. Of the two principal surfaces forming the solar cell module 100 that are parallel to the x-y plane, the principal surface disposed on the positive direction side along the z axis is the light receiving surface, and the principal surface disposed on the negative direction side along the z axis is the back surface. Hereinafter, the positive direction side along the z axis will be referred to as "light receiving surface side" and the negative direction side along the z axis will be referred to as "back surface side". Fig. 1 can be said to be a plan view of the solar cell module 100 as viewed from the light receiving surface side.

The solar cell module 100 includes an 11th solar cell 10aa, ..., a 46th solar cell 10df, which are generically referred to as solar cells 10, wires 14, bridge wiring members 16, terminal wiring members 18, a first frame 20a, a second frame 20b, a third frame 20c, and a fourth frame 20d, which are generically referred to as frames 20.

The first frame 20a extends in the x axis direction, and the second frame 20b extends in the negative direction along the y axis from the positive direction end of the first frame 20a along the x axis. Further, the third frame 20c extends in the negative direction along the x axis from the negative direction end of the second frame 20b along the y axis, and the fourth frame 20d connects the negative direction end of the third frame 20c along the x axis and the negative direction end of the first frame 20a along the x axis. The frames 20 bound the outer circumference of the solar cell module 100 and are made of a metal such as aluminum. The first frame 20a and the third frame 20c are longer than the second frame 20b and the fourth frame 20d, respectively, so that the solar cell module 100 has a rectangular shape longer in the x axis direction than in the y axis direction. The shape of the solar cell module 100 is not limited to the illustrated shape.

Each of the plurality of solar cells 10 absorbs incident light and generates photovoltaic power. In particular, the solar cell 10 generates an electromotive force from the light absorbed on the light receiving surface and also generates photovoltaic power from the light absorbed on the back surface. The solar cell 10 is formed by, for example, a semiconductor material such as crystalline silicon, gallium arsenide (GaAs), or indium phosphorus (InP). The structure of the solar cell 10 is not limited to any particular type. It is assumed here that crystalline silicon and amorphous silicon are stacked by way of example. The solar cell 10 is formed in a rectangular shape on the x-y plane but may have other shapes. For example, the solar cell 10 may have an octagonal shape. A plurality of finger electrodes (not shown in Fig. 1) extending in the y axis direction in a mutually parallel manner are disposed on the light receiving surface of each solar cell 10. The finger electrode is a collecting electrode. A plurality of oblique (extending in the diagonal direction) finger electrodes that change in the y axis direction as well as in the x axis direction are provided on the back surface of each solar cell 10. The finger electrodes on the back surface of the solar cell 10 may have the same structure as the finger electrodes on the light receiving surface of the solar cell 10.

The plurality of solar cells 10 are arranged in a matrix on the x-y plane. In this case, six solar cells 10 are arranged in the x axis direction. The six solar cells 10 arranged and disposed in the x axis direction are connected in series by the wires 14 so as to form one string 12. For example, a first string 12a is formed by connecting the 11th solar cell 10aa, the 12th solar cell 10ab, ..., and the 16th solar cell lOaf. The second string 12b through the fourth string 12d are similarly formed. As a result, the four strings 12 are arranged in parallel in the y axis direction. In this case, the number of solar cells 10 arranged in the x axis direction is larger than the number of solar cells 10 arranged in the y axis direction. The number of solar cells 10 included in the string 12 is not limited to "6", and the number of strings 12 is not limited to "4".

In order to form the string 12, the wires 14 connect the finger electrodes on the light receiving surface side of one of the solar cells 10 adjacent to each other in the x axis direction to the finger electrodes on the back surface side of the other. For example, the five wires 14 for connecting the 11th solar cell 10aa and the 12th solar cell 10ab adjacent to each other electrically connect the finger electrodes on the back surface side of the 11th solar cell 10aa and the finger electrodes on the light receiving surface side of the 12th solar cell 10ab. The number of wires 14 is not limited to "5". Connection between the wires 14 and the solar cell 10 will be described below.

The bridge wiring member 16 extends in the y axis direction and electrically connect the two adjacent strings 12. For example, the 16th solar cell lOaf located at the positive direction end of the first string 12a along the x axis and the 26th solar cell 10bf located at the positive direction end of the second string 12b along the x axis are electrically connected by the bridge wiring member 16. Further, the second string 12b and the third string 12c are electrically connected by the bridge wiring member 16 at the negative direction end along the x axis, and the third string 12c and the fourth string 12d are electrically connected by the bridge wiring member 16 at the positive direction end along the x axis. As a result, the plurality of strings 12 are connected in series by the bridge wiring member 16.

The bridge wiring member 16 is not connected to the 11th solar cell 10aa at the negative direction end of the first string 12a along the x axis. Instead the terminal wiring member 18 is connected. The terminal wiring member 18 is also connected to the 41st solar cell 10da at the negative direction end of the fourth string 12d along the x axis. A lead wiring member (not shown) is connected to the terminal wiring member 18. The lead wiring member is a wiring member for retrieving the electric power generated in the plurality of solar cells 10 outside the solar cell module 100.

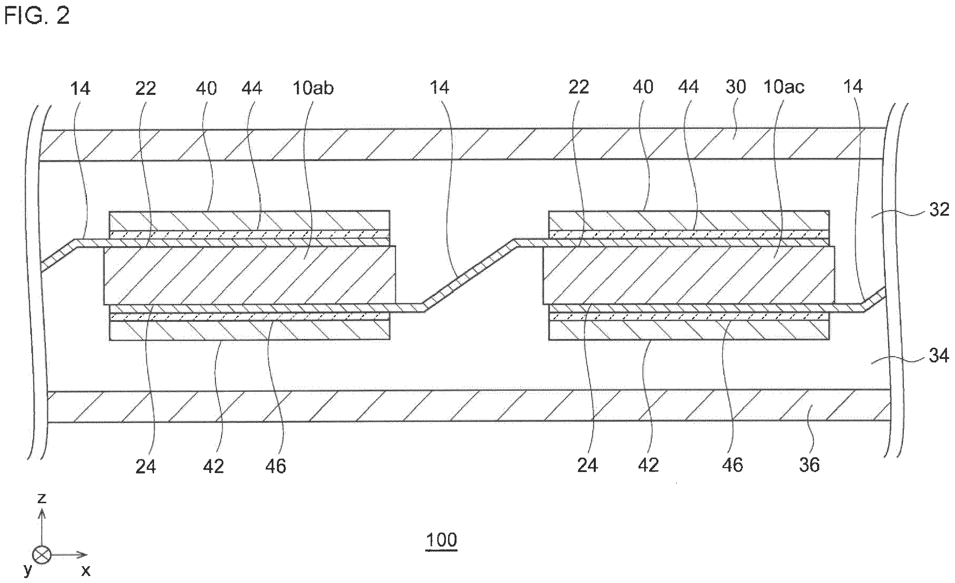

Fig. 2 is a cross sectional view showing a structure of the solar cell module 100 along the x axis and is an A-A' cross sectional view of Fig. 1. The solar cell module 100 includes a 12th solar cell 10ab, a 13th solar cell 10ac, the wires 14, a first protection member 30, a first encapsulant 32, a second encapsulant 34, a second protection member 36, a first film 40, a second film 42, a first adhesion layer 44, and a second adhesion layer 46. The top of Fig. 2 corresponds to the light receiving surface side, and the bottom corresponds to the back surface side. The figure shows the 12th solar cell 10ab and the 13th solar cell 10ac, but the other solar cells 10 also have the same structure.

The first protection member 30 is disposed on the light receiving surface side of the solar cell module 100 and protects the surface of the solar cell module 100. Further, the solar cell module 100 is shaped in a rectangle bounded by the frames 20 on the x-y plane. The first protection member 30 is formed by using a translucent and water shielding glass, translucent plastic, etc. The first protection member 30 increases the mechanical strength of the solar cell module 100.

The first encapsulant 32 is stacked on the back surface side of the first protection member 30. The first encapsulant 32 is disposed between the first protection member 30 and the solar cell 10 and adhesively attaches the first protection member 30 and the solar cell 10. For example, a thermoplastic resin film of polyolefin, ethylenevinyl acetate copolymer (EVA), polyvinyl butyral (PVB), polyimide, or the like may be used as the first encapsulant 32. A thermosetting resin may alternatively be used. The first encapsulant 32 is formed by a translucent sheet member having a surface of substantially the same dimension as the x-y plane in the first protection member 30.

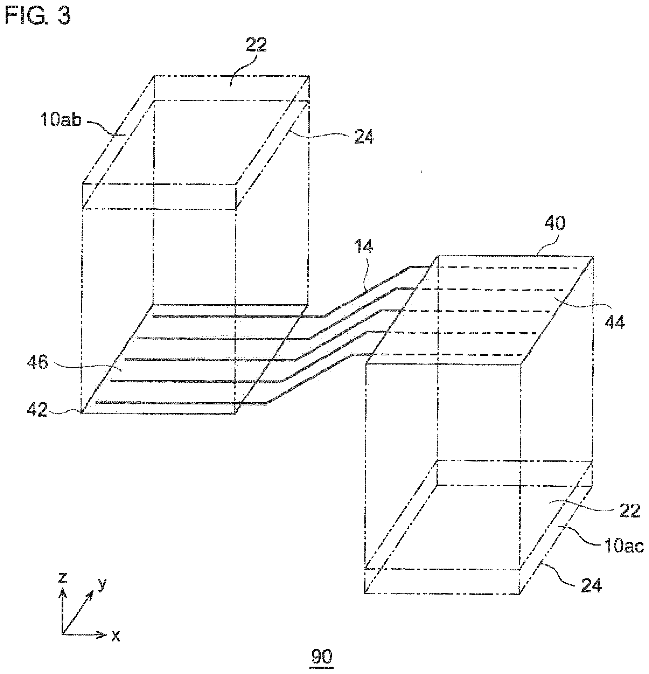

The 12th solar cell 10ab and the 13th solar cell 10ac are stacked on the back surface side of the first protection member 30. The solar cells 10 are provided such that the light receiving surface 22 faces the positive direction side along the z axis and the back surface 24 faces the negative direction side along the z axis. Given that the light receiving surface 22 is referred to as the "first surface", the back surface 24 is referred to as the "second surface". The wires 14, the first adhesion layer 44, and the first film 40 are provided on the light receiving surface 22 of the solar cell 10, and the wires 14, the second adhesion layer 46, and the second film 42 are provided on the back surface 24 of the solar cell 10. Fig. 3 will be used to describe the arrangement of the wires 14, the first film 40, and the second film 42 in the solar cell 10.

Fig. 3 is a perspective view showing a structure of a wire film 90 used in the solar cell module 100. The wire film 90 includes the wires 14, the first film 40, the second film 42, the first adhesion layer 44, and the second adhesion layer 46. The first film 40 is provided on the side of the light receiving surface 22 of one of the two adjacent solar cells 10 (for example, the 13th solar cell 10ac). The first adhesion layer 44 is provided on the surface of the first film 40 toward the 13th solar cell 10ac, and the plurality of wires 14 are provided on the first adhesion layer 44. The first adhesion layer 44 can adhesively attach the first film 40 and the plurality of wires 14 to the light receiving surface 22 of the 13th solar cell 10ac.

The second film 42 is provided on the side of the back surface 24 of the other of the two adjacent solar cells 10 (for example, the 12th solar cell 10ab). The second adhesion layer 46 is provided on the surface of the second film 42 toward the 12th solar cell 10ab, and the plurality of wires 14 are provided on the second adhesion layer 46. The second adhesion layer 46 can adhesively attach the second film 42 and the plurality of wires 14 to the back surface 24 of the 12th solar cell 10ab.

The wire film 90 configured as described above and the solar cell module 100 are manufactured separately. When the solar cell module 100 is manufactured, the first adhesion layer 44 is adhesively attached to the light receiving surface 22 of the 13th solar cell 10ac, and the second adhesion layer 46 is adhesively attached to the back surface 24 of the 12th solar cell 10ab. By adhesive attachment as described above, the wires 14 electrically connect the finger electrodes (not shown) on the light receiving surface 22 of the 13th solar cell 10ac to the finger electrodes (not shown) on the back surface 24 of the 12th solar cell 10ab.

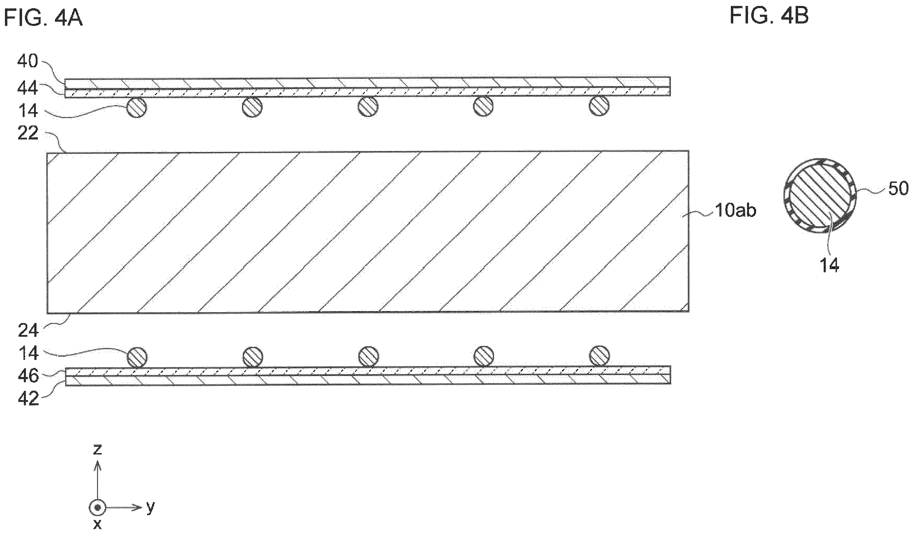

The structure of the first film 40 and the second film 42 shown in Fig. 3 will be described in further detail. Figs. 4A-4B are cross-sectional views showing a structure of the first film 40 and the second film 42 exhibited before they are attached to the solar cell 10. In particular, Fig. 4A is a cross-sectional view exhibited when the neighborhood of the 12th solar cell 10ab of Fig, 2 is severed along the y axis and is a cross-sectional view exhibited before the first film 40 and the second film 42 are attached to the 12th solar cell 10ab. As shown in Fig. 2, the first film 40 and the second film 42 shown in Fig. 4A are included in mutually different wire films 90.

The first film 40 is formed by a transparent resin film of, for example, polyethylene terephthalate (PET). The first film 40 has rectangular shape of a size equal to or smaller than the size of the solar cell 10 on the x-y plane. For example, polyolefin is used in the first adhesion layer 44 provided on the back surface side of the first film 40, but EVA may be used. The first adhesion layer 44 has a shape similar to that of the first film 40 on the x-y plane. A plurality of wires 14 are provided on the back surface side of the first adhesion layer 44.

Fig. 4B is a cross-sectional view of the wire 14 in the same direction as that of Fig. 4A. The wire 14 extends in a cylindrical shape and has a circular cross section. The wire 14 has a diameter of 100-500 µm, and, preferably, 200-400 µm, and so is thinner than the width of 1-2 mm of a tab line commonly used in a solar cell module. The wire 14 is configured to contain, for example, copper. The outer circumference of the wire 14 is coated with a solder layer 50 having a thickness of 5 µm to 30 µm. The solder layer 50 is formed by a solder having a low melting point. For example, the solder has a tin-silver-bismuth composition. In that case, the melting point of the solder layer 50 is about 140°C. Reference is made back to Fig. 4A. The figure shows five wires 14 by way of example, but, generally, the number of wires 14 is 10-20, which is larger than the number of tab lines commonly used in a solar cell module.

Like the first film 40, the second film 42 is formed by a transparent resin film. The second film 42 may be formed by a non-transparent resin film. For example, the second film 42 may be a white resin film. The second film 42 has rectangular shape of a size equal to or smaller than the size of the solar cell 10 on the x-y plane. As in the first adhesion layer 44, polyolefin or EVA is used in the second adhesion layer 46 provided on the light receiving side of the second film 42. The second adhesion layer 46 has a shape similar to that of the second film 42 on the x-y plane. The plurality of wires 14 are provided on the light receiving surface side of the second adhesive layer 46. The structure of the wire 14 is as shown in Fig. 4B. When the wire 14 provided on the back surface side of the first adhesion layer 44 is referred to as the "first wiring member", the wire 14 provided on the light receiving surface side of the second adhesion layer 46 is referred to as the "second wiring member". Reference is made back to Fig. 2.

By adhesively attaching the first film 40 and the second film 42 to the other solar cells 10, the string 12 as shown in Fig. 1 is formed. The second encapsulant 34 is stacked on the back surface side of the first encapsulant 32. The second encapsulant 34 encapsulates the plurality of solar cells 10, the wires 14, the bridge wiring members 16, the terminal wiring members 18, the first films 40, the second films 42, etc., sandwiching the cells, the wires, the members, and the films between the first encapsulant 32 and the second encapsulant 34. In other words, the first encapsulant 32 encapsulates the solar cell 10 from the side of the light receiving surface 22 to which the wire 14 is adhesively attached by the first adhesion layer 44, and the second encapsulant 34 encapsulates the solar cell 10 from the side of the back surface 24 to which the wire 14 is adhesively attached by the second adhesion layer 46. The second encapsulant 42b may be made of a material similar to that of the first encapsulant 42a. Alternatively, the second encapsulant 34 may be integrated with the first encapsulant 32 by heating the encapsulants in a laminate cure process.

The second protection member 36 is stacked on the back surface side of the second encapsulant 34 so as to face the first protection member 30. The second protection member 36 protects the back surface side of the solar cell module 100 as a back sheet. A resin film of, for example, PET, polytetrafluoroethylene (PTFE), etc., a stack film having a structure in which an Al foil is sandwiched by resin films of polyolefin, or the like is used as the second protection member 36.

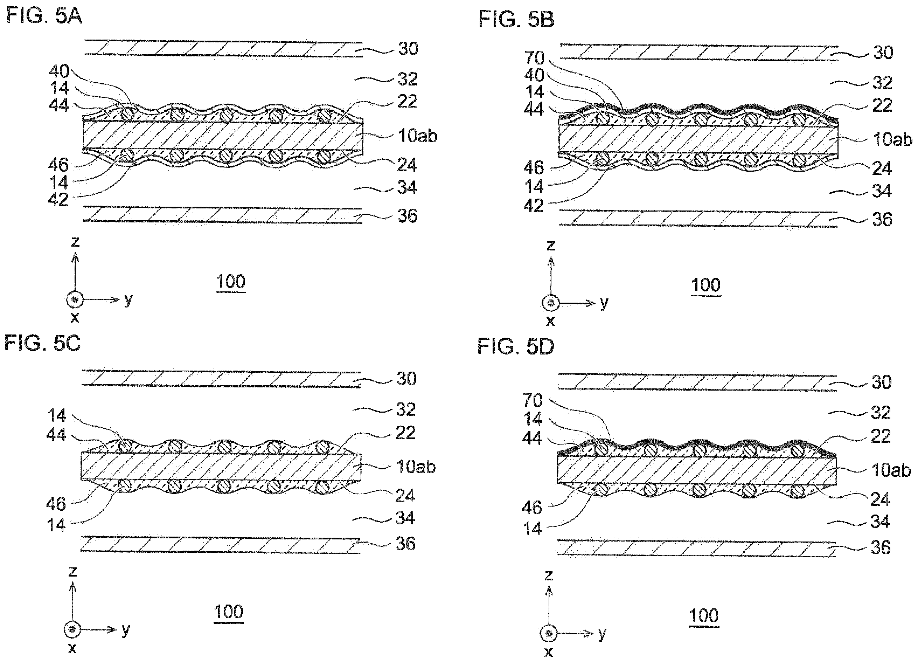

Figs. 5A-5D are further cross-sectional views showing a structure of the solar cell module 100. Fig. 5A is a cross-sectional view exhibited after the first film 40 and the second film 42 shown in Fig. 4A are attached to the solar cell 10ab and shows a view in the same direction as that of Fig. 4A. As described already, the wire 14 is connected by the first adhesion layer 44 to the light receiving surface 22 of the 12th solar cell 10ab, and the first film 40 sandwiches the first adhesion layer 44 and the wire 14 between the first film 40 and the light receiving surface 22. The first encapsulant 32 is provided on the surface of the first film 40 opposite to the first adhesion layer 44. The wire 14 is connected by the second adhesion layer 46 to the back surface 24 of the 12th solar cell 10ab, and the second film 42 sandwiches the second adhesion layer 46 and the wire 14 between the second film 42 and the back surface 24. The second encapsulant 34 is provided on the surface of the second film 42 opposite to the second adhesion layer 46.

If there is an effusion of copper contained in the wire 14, the first encapsulant 32, the second encapsulant 34, the first adhesion layer 44, and the second adhesion layer 46 are impacted by the copper hazards. Copper hazards change the color of the first encapsulant 32, the second encapsulant 34, the first adhesion layer 44, and the second adhesion layer 46 to, for example, brown. The change in color is revealed when the solar cell module 100 is viewed from outside and detracts from the aesthetic appearance of the solar cell module 100. This embodiment inhibits the impact from copper hazards by containing an antioxidant in the first adhesion layer 44 and the second adhesion layer 46. Further, an antioxidant may be contained in the first encapsulant 32 and the second encapsulant 34. An antioxidant may be selected from organic antioxidants as desired. Hindered phenol-based antioxidant, amine antioxidants, phosphorous antioxidants, etc. are exemplified.

While it is effective to increase the amount of antioxidant to inhibit the impact from copper hazards, an excessive increase in the amount of antioxidant results in a change in physical property in the first adhesion layer 44, etc. An example of the change in physical property is lower adhesiveness. Thus, an increase in the amount of antioxidant is desired in order to inhibit the impact from copper hazards in the first adhesion layer 44, etc., and a decrease in the amount of antioxidant is desired in order to inhibit a change in physical property in the first adhesion layer 44, etc.

The first adhesion layer 44 and the second adhesion layer 46 are placed in intimate contact with the wire 14 and so is directly affected by the copper hazards from the wire 14. Meanwhile, the first encapsulant 32 and the second encapsulant 34 are provided such that the first film 40 is interposed between the first encapsulant 32 and the wire 14 and the second film 42 is interposed between the second encapsulant 34 and the wire 14. In this embodiment, therefore, the amount of antioxidant contained in the first adhesion layer 44 and the second adhesion layer 46 is configured to be equal to or larger than the amount of antioxidant contained in the first encapsulant 32 and the second encapsulant 34. Further, a person viewing the solar cell module 100 usually views it by facing the first protection member 30. Therefore, the constituting elements provided on the side of the light receiving surface of the solar cell 10 is more noticeable and affects the aesthetic appearance more seriously than the constituting elements provided on the side of the back surface 24 of the solar cell 10. This is equivalent to the fact that the former is more easily affected by the impact from degraded aesthetic appearance due to copper hazards than the latter. In this regard, the amount of antioxidant contained in the first adhesion layer 44 is configured to be equal to or larger than the amount of antioxidant contained in the second adhesion layer 46. Further, the amount of antioxidant contained in the first encapsulant 32 may be configured to be larger than the amount of antioxidant contained in the second encapsulant 34. The amount of antioxidant is defined by the amount of antioxidant contained in a certain volume and so can be referred to as density.

To summarize the above, the amounts are related such that the amount of antioxidant contained in the first adhesion layer 44 ≥ the amount of antioxidant contained in the second adhesion layer 46 ≥ the amount of antioxidant contained in the first encapsulant 32 ≥ the amount of antioxidant contained in the second encapsulant 34. Given that this relationship holds, the amount of antioxidant contained in the first adhesion layer 44 is not less than 0.005 wt% and not more than 1 wt%, the amount of antioxidant contained in the second adhesion layer 46 is not less than 0.004 wt% and not more than 0.8 wt%, the amount of antioxidant contained in the first encapsulant 32 is 0.6 wt% or less, and the amount of antioxidant contained in the second encapsulant 34 is 0.2 wt% or less. The first encapsulant 32 may not contain an antioxidant, and the second encapsulant 34 may not contain an antioxidant.

The temperature of the first adhesion layer 44 and the second adhesion layer 46 is increased by manufacturing the solar cell module 100 by lamination or by using the solar cell module 100 under sunlight. When the temperature of the first adhesion layer 44 or the second adhesion layer 46 goes higher than the melting point, the fluidity is increased, and effusion of the antioxidant results. This detracts from the effect of inhibiting copper hazards by the antioxidant. In order to inhibit the occurrence of such a phenomenon, the melting point of the first adhesion layer 44 is configured to be higher than the melting point of the second adhesion layer 46. For example, polyolefin having a melting point of 105°C is used in the first adhesion layer 44, and, polyolefin having a melting point of 100°C is used in the second adhesion layer 46. This is based on an assumption that the temperature will reach a maximum of 90°C by using the solar cell module 100 under sunlight.

Fig. 5B shows a variation of Fig. 5A. The 12th solar cell 10ab, the wire 14, the first protection member 30, the first encapsulant 32, the second encapsulant 34, the second protection member 36, the first film 40, the second film 42, the first adhesion layer 44, and the second adhesion layer 46 are arranged in a manner similar to that of Fig. 5A. The low sticking force layer 70 is provided between the first film 40 and the first encapsulant 32. The low sticking force layer 70 is a polyolefin layer adhering to the first film 40 with a smaller sticking force than to to the first encapsulant 32. The low sticking force layer 70 is, for example, a low-molecular polymer. A 180° peel test using a pull speed of 50 mm/min and a slit width of 10 mm reveals that the peel strength with respect to the first film 40 is 0.1-3.0 N, and the peel strength with respect to the first encapsulant 32 is 0.2-6.0 N. This is to make it easy for the low sticking force layer 70 to be peeled from the first film 40 when the sticking force of the first adhesion layer 44 is lowered by the antioxidant and an external force is exerted in a direction in which the first encapsulant 32 and the first film 40 are removed. As a result of the low sticking force layer 70 being peeled from the first film 40, the connection between the wires 14 and the 12th solar cell 10ab is maintained, and the output of power is secured.

Fig. 5C shows a variation of Fig. 5A. The figure shows a configuration in which the first film 40 and the second film 42 are omitted from the configuration of Fig. 5A. Fig. 5D shows a variation of Fig. 5B. The figure shows a configuration in which the first film 40 and the second film 42 are omitted from the configuration of Fig. 5B. The low sticking force layer 70 is a polyolefin layer adhering to the first adhesion layer 44 with a smaller sticking force than to the first encapsulant 32. The low sticking force layer 70 is, for example, a low-molecular polymer. A 180° peel test using a pull speed of 50 mm/min and a slit width of 10 mm reveals that the peel strength with respect to the first film 40 is 5.0-25.0 N, and the peel strength with respect to the first encapsulant 32 is 10.0-50.0 N.

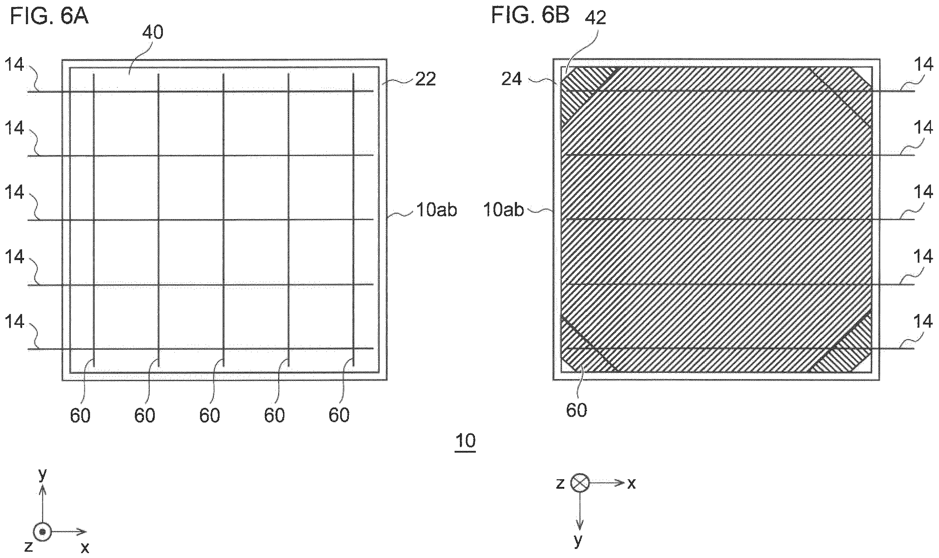

Figs. 6A-6B are plan views showing a structure of the solar cell 10. Fig. 6A is a plan view showing the 12th solar cell 10ab of Fig. 5A as viewed from the side of the light receiving surface 22. A plurality of finger electrodes 60 extending in the y axis direction are arranged in the x axis direction on the light receiving surface 22. The finger electrode 60 is made of, for example, silver. The plurality of wires 14 extend on the light receiving surface 22 from the negative direction side along the x axis so as to intersect the plurality of finger electrodes 60. The plurality of wires 14 are sandwiched between the first film 40 and the light receiving surface 22. The first film 40 is configured to be smaller than the light receiving surface 22.

Fig. 6B is a plan view showing the 12th solar cell 10ab of Fig. 5A as viewed from the side of the back surface 24. A plurality of oblique (extending in the diagonal direction) finger electrodes 60 that change in the y axis direction as well as in the x axis direction are provided on the back surface 24 in a substantially parallel manner. The number of finger electrodes 60 on the back surface 24 is larger than the number of finger electrodes 60 on the light receiving surface 22. More specifically, the interval between adjacent finger electrodes 60 on the back surface 24 is configured to be smaller than the interval between adjacent finger electrodes 60 on the light receiving surface 22. As in the light receiving surface 22, the plurality of finger electrodes 60 extending in the y axis direction may be arranged in the x axis direction on the back surface 24. The plurality of wires 14 extend on the back surface 24 from the positive direction side along the x axis so as to intersect the plurality of finger electrodes 60. The plurality of wires 14 are sandwiched between the second film 42 and the back surface 24. The second film 42 is configured to be smaller than the back surface 24.

A description will now be given of a method of manufacturing the solar cell module 100. First, the wire film 90 shown in Fig. 3 is prepared to connect two adjacent solar cells 10. The string 12 is produced by layering the first film 40 of the wire film 90 on one of the two adjacent solar cells 10 and layering the second film 42 of the wire film 90 on the other of the two adjacent solar cells 10. A stack is produced by layering the first protection member 30, the first encapsulant 32, the string 12, the second encapsulant 34, and the second protection member 36 in the stated order in the positive-to-negative direction along the z axis. This is followed by a laminate cure process performed for the stack. In this process, air is drawn from the stack, and the stack is heated and pressurized so as to be integrated. In vacuum lamination in the laminate cure process, the temperature is set to about 50-160°, as mentioned before. Further, a terminal box is attached to the second protection member 36 using an adhesive.

According to this embodiment, the amount of antioxidant contained in the first adhesion layer 44 and the second adhesion layer 46 is equal to or larger than the amount of antioxidant contained in the first encapsulant 32 so that the impact from copper hazards can be inhibited. Further, the amount of antioxidant contained in the first adhesion layer 44 and the second adhesion layer 46 is equal to or larger than the amount of antioxidant contained in the first encapsulant 32 so that the change in physical property in the first encapsulant 32 is inhibited. Further, the wire 14 contains copper, and the impact from copper hazards can be inhibited. Further, the amount of antioxidant contained in the first adhesion layer 44 is equal to or larger than the amount of antioxidant contained in the second adhesion layer 46 so that the aesthetic appearance of the solar cell module 100 is inhibited from being degraded.

Further, the melting point of the first adhesion layer 44 is higher than the melting point of the second adhesion layer 46 so that effusion of the antioxidant toward the first encapsulant 32 as a result of the first adhesion layer 44 becoming fluid at a high temperature can be inhibited. Further, the low sticking force layer 70 adhering to the first adhesion layer 44 with a smaller sticking force than to the first encapsulant 32 is provided so that the connection between the wires 14 and the finger electrodes 60 can be maintained even when the sticking force in the first adhesion layer 44 is lowered. Further, the low sticking force layer 70 adhering to the first film 40 with a smaller sticking force than to the first encapsulant 32 is provided so that the connection between the wires 14 and the finger electrodes 60 can be maintained even when the sticking force in the first adhesion layer 44 is lowered.

A summary of an embodiment of the present disclosure is given below. A solar cell module (100) according to an embodiment of the present disclosure includes: a solar cell (10) including a light receiving surface (22) and a back surface (24) that face in opposite directions; a first adhesion layer (44) that adhesively attaches a wire (14) to the light receiving surface (22); a second adhesion layer (46) that adhesively attaches a wire (14) to the back surface (24); a first encapsulant (32) that encapsulates the solar cell (10) from a side of the light receiving surface (22) to which the wire (14) is adhesively attached by the first adhesion layer (44); and a second encapsulant (34) that encapsulates the solar cell (10) from a side of the back surface (24) to which the wire (14) is adhesively attached by the second adhesion layer (46). An amount of antioxidant contained in the first adhesion layer (44) and the second adhesion layer (46) is equal to or larger than an amount of antioxidant contained in the first encapsulant (32).

The wire (14) contains copper.

An amount of antioxidant contained in the first adhesion layer (44) may be equal to or larger than an amount of antioxidant contained in the second adhesion layer (46).

A melting point of the first adhesion layer (44) may be higher than a melting point of the second adhesion layer (46).

The solar cell module may further include: a low sticking force layer (70) provided between the first adhesion layer (44) and the first encapsulant ()32 and adhering to the first adhesion layer (44) with a lower sticking force than to the first encapsulant (32).

The solar cell module may further include: a first film (40) that sandwiches the first adhesion layer (44) between the first film (40) and the light receiving surface (22); and a low sticking force layer (70) provided between the first film (40) and the first encapsulant (32) and adhering to the first film (40) with a lower sticking force than to the first encapsulant (32).

### (Embodiment 2)

Like embodiment 1, embodiment 2 relates to a solar cell module wherein an antioxidant is contained in the first adhesion layer, etc. in order to inhibit the impact from copper hazards. In embodiment 2, the finger electrodes contain copper. The solar cell module 100 according to embodiment 2 is of the same type as that of Fig. 1 through Figs. 6A-6B. The description below highlights a difference from the foregoing embodiment.

As described above, Fig. 6A shows the plurality of finger electrodes 60 provided on the light receiving surface 22, and Fig. 6B shows the plurality of finger electrodes 60 provided on the back surface 24. Since the number of finger electrodes 60 on the back surface 24 is larger than the number of finger electrodes 60 on the light receiving surface 22, the area of the finger electrodes 60 is larger than the area of the finger electrodes 60 on the light receiving surface 22. For this reason, the amount of effusion of copper from the finger electrodes 60 on the back surface 24 is larger than the amount of effusion of copper from the finger electrodes 60 on the light receiving surface 22. The impact from copper hazards is larger on the back surface 24 than on the light receiving surface 22.

The structure of the solar cell module 100 according to embodiment 2 is as shown in Fig. 5A and 5C. The amount of antioxidant contained in the second adhesion layer 46 is configured to be equal to or larger than the amount of antioxidant contained in the first adhesion layer 44. Further, the amount of antioxidant contained in the second encapsulant 34 may be configured to be equal to or larger than the amount of antioxidant contained in the first encapsulant 32. In this case, too, the amount of antioxidant is defined by the amount of antioxidant contained in a certain volume and so can be referred to as density.

To summarize the above, the amounts are related such that the amount of antioxidant contained in the second adhesion layer 46 ≥ the amount of antioxidant contained in the first adhesion layer 44 ≥ the amount of antioxidant contained in the second encapsulant 34 ≥ the amount of antioxidant contained in the first encapsulant 32. Further, the amounts may be related such that the amount of antioxidant contained in the second adhesion layer 46 ≥ the amount of antioxidant contained in the first adhesion layer 44 ≥ the amount of antioxidant contained in the first encapsulant 32 ≥ the amount of antioxidant contained in the second encapsulant 34. Given that this relationship holds, the amount of antioxidant contained in the second adhesion layer 46 is not less than 0.005 wt% and not more than 1.0 wt%, the amount of antioxidant contained in the first adhesion layer 44 is not less than 0.004 wt% and not more than 0.8 wt%, the amount of antioxidant contained in the second encapsulant 34 is 0.6 wt% or less, and the amount of antioxidant contained in the first encapsulant 32 is 0.2 wt% or less. The first encapsulant 32 may not contain an antioxidant, and the second encapsulant 34 may not contain an antioxidant.

In order to inhibit outward effusion of the antioxidant from occurring as a result of the temperature of the first adhesion layer 44 or the second adhesion layer 46 going higher than the melting point and the fluidity being increased accordingly, the melting point of the second adhesion layer 46 is configured to be higher than the melting point of the first adhesion layer 44. For example, polyolefin having a melting point of 100°C is used in the first adhesion layer 44, and, polyolefin having a melting point of 105°C is used in the second adhesion layer 46.

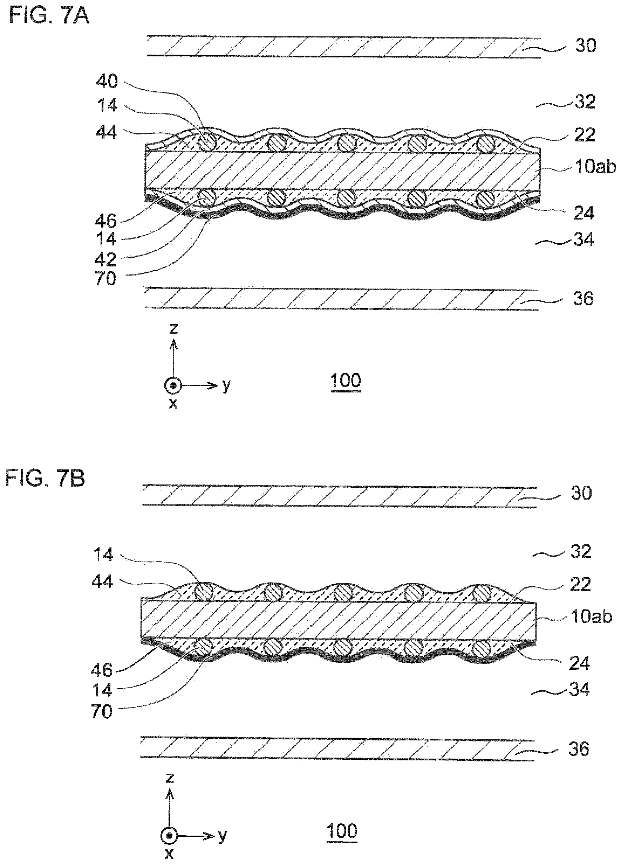

Figs. 7A-7B are cross-sectional views showing a structure of the solar cell module 100. Fig. 7A shows a variation of Fig. 5B. Like Fig. 5B, Fig. 7A shows that the low sticking force layer 70 is included. The low sticking force layer 70 is provided between the second film 42 and the second encapsulant 34. The low sticking force layer 70 is a polyolefin layer adhering to the second film 42 with a smaller sticking force than to the second encapsulant 34. This is to make it easy for the low sticking force layer 70 to be peeled from the second film 42 when the sticking force of the second adhesion layer 46 is lowered by the antioxidant and an external force is exerted in a direction in which the second encapsulant 34 and the second film 42 are removed. As a result of the low sticking force layer 70 being peeled from the second film 42, the connection between the wires 14 and the 12th solar cell 10ab is maintained, and the output of power is secured.

Fig. 7B shows a variation of Fig. 5D. Like Fig. 5D, Fig. 7B shows that the low sticking force layer 70 is included. The low sticking force layer 70 is a polyolefin layer adhering to the second adhesion layer 46 with a smaller sticking force than to the second encapsulant 34.

According to this embodiment, the amount of antioxidant contained in the second adhesion layer 46 is equal to or larger than the amount of antioxidant contained in the first adhesion layer 44 even if the area of the wires 14 provided on the back surface 24 is is larger than the area of the wires 14 provided on the light receiving surface 22. Therefore, the impact from copper hazards can be inhibited. Further, the amount of antioxidant contained in the second adhesion layer 46 is equal to or larger than the amount of antioxidant contained in the first adhesion layer 44 even if the area of the wires 14 provided on the back surface 24 is larger than the area of the wires 14 provided on the light receiving surface 22. Therefore, the change in physical property in the first adhesion layer 44 is inhibited. Further, the melting point of the second adhesion layer 46 is higher than the melting point of the first adhesion layer 44 so that effusion of the antioxidant toward the second encapsulant 34 as a result of the second adhesion layer 46 becoming fluid at a high temperature can be inhibited. Further, the low sticking force layer 70 adhering to the second adhesion layer 46 with a smaller sticking force than to the second encapsulant 34 is provided so that the connection between the wires 14 and the finger electrodes 60 can be maintained even when the sticking force in the second adhesion layer 46 is lowered. Further, the low sticking force layer 70 adhering to the first film 40 with a smaller sticking force than to the second encapsulant 34 is provided so that the connection between the wires 14 and the finger electrodes 60 can be maintained even when the sticking force in the second adhesion layer 46 is lowered.

A summary of an embodiment of the present disclosure is given below. A first electrode containing copper may be provided on the light receiving surface (22), a second electrode containing copper and having a larger area than the first electrode may be provided on the back surface (24), and the amount of antioxidant contained in the second adhesion layer (46) may be equal to or larger than the amount of antioxidant contained in the first adhesion layer (44).

A melting point of the second adhesion layer (46) may be higher than a melting point of the second adhesion layer (44).

The solar cell module may further include: a low sticking force layer (70) provided between the second adhesion layer (46) and the second encapsulant (34) and adhering to the second adhesion layer (46) with a lower sticking force than to the second encapsulant (34).

The solar cell module may further include: a first film (40) that sandwiches the second adhesion layer (46) between the first film (40) and the back surface (24); and a low sticking force layer (70) provided between the first film (40) and the second encapsulant (34) and adhering to the first film (40) with a lower sticking force than to the second encapsulant (34).

Described above is an explanation based on an exemplary embodiment. The embodiment is intended to be illustrative only and it will be understood by those skilled in the art that various modifications to constituting elements and processes could be developed and that such modifications are also within the scope of the present disclosure.

While the foregoing has described what are considered to be the best mode and/or other examples, it is understood that various modifications may be made therein and that the subject matter disclosed herein may be implemented in various forms and examples, and that they may be applied in numerous applications, only some of which have been described herein. It is intended by the following claims to claim any and all modifications and variations that fall within the true scope of the present teachings.

## Claims

1. A solar cell module (100) comprising:
a solar cell (10) including a first surface (22) and a second surface (24) that face in opposite directions;
a first adhesion layer (44) that adhesively attaches a first wiring member (14) to the first surface (22);
a second adhesion layer (46) that adhesively attaches a second wiring member (14) to the second surface (24);
a first encapsulant (32) that encapsulates the solar cell (10) from a side of the first surface (22) to which the first wiring member (14) is adhesively attached by the first adhesion layer (44); and
a second encapsulant (34) that encapsulates the solar cell (10) from a side of the second surface (24) to which the second wiring member (14) is adhesively attached by the second adhesion layer (46), wherein
an amount of antioxidant contained in the first adhesion layer (44) and the second adhesion layer (46) is equal to or larger than an amount of antioxidant contained in the first encapsulant (32).

2. The solar cell module (100) according to claim 1, **characterized in that**
the first wiring member (14) and the second wiring member (14) contain copper.

3. The solar cell module (100) according to claim 1 or 2, **characterized in that**
an amount of antioxidant contained in the first adhesion layer (44) is equal to or larger than an amount of antioxidant contained in the second adhesion layer (46).

4. The solar cell module (100) according to claim 3, **characterized in that**
a melting point of the first adhesion layer (44) is higher than a melting point of the second adhesion layer (46).

5. The solar cell module (100) according to claim 3 or 4, further comprising:
a low sticking force layer (70) provided between the first adhesion layer (44) and the first encapsulant (32) and adhering to the first adhesion layer (44) with a lower sticking force than to the first encapsulant (32).

6. The solar cell module (100) according to claim 3 or 4, further comprising:
a film (40) that sandwiches the first adhesion layer (44) between the film (40) and the first surface (22); and
a low sticking force layer (70) provided between the film (40) and the first encapsulant (32) and adhering to the film (40) with a lower sticking force than to the first encapsulant (32).

7. The solar cell module (100) according to claim 1 or 2, **characterized in that**
a first electrode containing copper is provided on the first surface (22),
a second electrode containing copper and having a larger area than the first electrode is provided on the second surface (24), and
the amount of antioxidant contained in the second adhesion layer (46) is equal to or larger than the amount of antioxidant contained in the first adhesion layer (44).

8. The solar cell module (100) according to claim 7, **characterized in that**
a melting point of the second adhesion layer (46) is higher than a melting point of the second adhesion layer (44).

9. The solar cell module (100) according to claim 7 or 8, further comprising:
a low sticking force layer (70) provided between the second adhesion layer (46) and the second encapsulant (34) and adhering to the second adhesion layer (46) with a lower sticking force than to the second encapsulant (34).

10. The solar cell module (100) according to claim 7 or 8, further comprising:
a film (40) that sandwiches the second adhesion layer (46) between the film (40) and the second surface (24) ; and
a low sticking force layer (70) provided between the film (40) and the second encapsulant (34) and adhering to the film (40) with a lower sticking force than to the second encapsulant (34).
